# EUROPEAN PATENT APPLICATION

(11) **EP 4 181 210 A1**
(43) Date of publication of application: **17.05.2023**
(21) Application number: 22207221.7
(22) Date of filing: 14.11.2022
(51) Int. Cl.: H01L 29/51, H01L 29/78

(54) **SEMICONDUCTOR DEVICE AND SEMICONDUCTOR APPARATUS INCLUDING THE SEMICONDUCTOR DEVICE**

(30) Priority: 16.11.2021 KR 20210158042
(71) Applicant: Samsung Electronics Co., Ltd., Gyeonggi-do 16677 (KR)
(72) Inventor: BAE, Hagyoul, Suwon-si (KR); CHOE, Dukhyun, Suwon-si (KR); HEO, Jinseong, Suwon-si (KR); LEE, Yunseong, Suwon-si (KR); NAM, Seunggeol, Suwon-si (KR); LEE, Hyunjae, Suwon-si (KR)
(74) Representative: Elkington and Fife LLP

(57) **Abstract**

Provided are a semiconductor device (100) and a semiconductor apparatus including the semiconductor device. The semiconductor device includes a substrate (110) having a channel layer (115) comprising a dopant, a ferroelectric layer (140) on the channel layer; and a gate (150) on the ferroelectric layer. The channel layer has a doping concentration of 1×10¹⁵ cm⁻³ to 1×10²¹ cm⁻³.

## Description

### FIELD OF THE INVENTION

Some example embodiments relate to a semiconductor device and/or a semiconductor apparatus including the semiconductor device.

### BACKGROUND OF THE INVENTION

Ferroelectrics are materials with ferroelectricity that maintain spontaneous polarization by aligning internal electric dipole moments even when no external electric field is applied thereto. Research has been made to improve the performance of a semiconductor device by applying such a ferroelectric to the semiconductor device.

### SUMMARY OF THE INVENTION

Provided is a semiconductor device and/or a semiconductor apparatus including the semiconductor device.

Additional aspects will be set forth in part in the description which follows and, in part, will be apparent from the description, and/or may be learned by practice of the various example embodiments.

According to some example embodiments, a semiconductor device includes a substrate having a channel layer in or on the substrate and including a dopant, a ferroelectric layer on the channel layer, and a gate on the ferroelectric layer. The channel layer may have a doping concentration of greater than or equal to 1×10¹⁵ cm⁻³ and less than or equal to 1×10²¹ cm⁻³.

The channel layer may be in an upper portion of the substrate integrally with the substrate, and a source and a drain may be at opposite sides of the channel layer.

The channel layer may be at least partially on the substrate separate from the substrate, and a source and a drain may be at opposite sides of the channel layer.

The channel layer may include at least one of Si, Ge, SiGe, a group III-V semiconductor, an oxide semiconductor, a nitride semiconductor, an oxynitride semiconductor, a two-dimensional (2D) semiconductor material, quantum dots, or an organic semiconductor.

A dopant included in the channel layer may include at least one of a group III element or a group V element.

The channel layer may have a doping concentration of greater than or equal to 1×10¹⁵ cm⁻³ and less than or equal to 1×10¹⁸ cm⁻³.

The ferroelectric layer may include one or more of a fluorite-based material or a perovskite-based material. The ferroelectric layer may include at least one of a hafnium oxide, a zirconium oxide, or a hafnium-zirconium oxide. The ferroelectric layer may further include a dopant of at least one of Si, Al, La, Y, Sr, or Gd.

The semiconductor device may further include a dielectric layer between the channel layer and the ferroelectric layer. The dielectric layer may include at least one of a silicon oxide, a silicon nitride, an aluminum oxide, a silicon oxynitride, a lanthanum oxide, or an yttrium oxide.

The channel layer may have one or more of a sheet channel structure, a fin channel structure, or a gate-all-around channel structure.

The gate may include a metal, a metal nitride, polysilicon, or a 2D conductive material.

According to some example embodiments, a semiconductor apparatus includes a field effect transistor, and a capacitor electrically connected to the field effect transistor. The field effect transistor includes a substrate having a channel layer in or on the substrate and including a dopant, a ferroelectric layer on the channel layer, and a gate on the ferroelectric layer. The channel layer may have a doping concentration of greater than or equal to 1 ×10¹⁵ cm⁻³ and less than or equal to 1×10²¹ cm⁻³.

The channel layer may be in an upper portion of the substrate integrally with the substrate, and a source and a drain may be provided at opposite sides of the channel layer.

The channel layer may be at least partially on the substrate separate from the substrate, and a source and a drain may be at opposite sides of the channel layer.

The channel layer may include at least one of Si, Ge, SiGe, a group III-V semiconductor, an oxide semiconductor, a nitride semiconductor, an oxynitride semiconductor, a 2D semiconductor material, quantum dots, or an organic semiconductor.

The channel layer may have a doping concentration of greater than or equal to 1×10¹⁵ cm⁻³ and less than or equal to 1×10¹⁸ cm⁻³.

The ferroelectric layer may include one or more of a fluorite-based material or perovskite. The ferroelectric layer may include at least one of a hafnium oxide, a zirconium oxide, or a hafnium-zirconium oxide. The ferroelectric layer may further include a dopant of at least one of Si, Al, La, Y, Sr, or Gd.

The field effect transistor may further include a dielectric layer between the channel layer and the ferroelectric layer. The dielectric layer may include at least one of a silicon oxide, a silicon nitride, an aluminum oxide, a silicon oxynitride, a lanthanum oxide, or an yttrium oxide.

The gate may include a metal, a metal nitride, polysilicon, or a 2D conductive material.

According to some example embodiments, an electronic apparatus includes the above-described semiconductor apparatus.

According to various example embodiments, a semiconductor device may include a channel layer comprising dopants at a concentration of greater than or equal to 1×10¹⁵ cm⁻³ and less than or equal to 1×10²¹ cm⁻³, and a ferroelectric layer on the channel layer.

The semiconductor device may further include a substrate, the channel layer integral in the substrate, and a source and a drain , the source and the drain integral with the substrate and at opposite ends of the channel layer.

The source and the drain may include first dopants of a first conductivity type opposite to a conductivity type of second dopants in the channel layer.

According to some example embodiments, a method of fabricating the semiconductor device may include provisioning the substrate, forming the channel layer by implanting the substrate with the second dopants at a first dose, forming the ferroelectric layer on the channel layer, and forming the source and the drain by implanting the substrate with the first dopants at a second dose.

The forming the source and the drain may be performed after the forming the ferroelectric layer.

### BRIEF DESCRIPTION OF THE DRAWINGS

The above and other aspects, features, and/or advantages of certain example embodiments of the disclosure will be more apparent from the following description taken in conjunction with the accompanying drawings, in which:
FIG. 1 is a cross-sectional view of a semiconductor device according to various example embodiments;
FIG. 2 is a graph showing an effect of improving the subthreshold swing (SS) characteristics of the semiconductor device of FIG. 1;
FIG. 3 is a graph showing the polarization P-voltage V characteristics of a capacitor having a metal-ferroelectric-metal (MFM) structure and a capacitor having a metal-ferroelectric-insulator-metal (MFIM) structure;
FIG. 4 is a graph showing a simulation result of the polarization P-voltage V characteristics when the doping concentration of a channel layer in the semiconductor device of FIG. 1 is 1×10²⁰ cm⁻³ and 5×10¹⁷ cm⁻³;
FIGS. 5A to 5C are graphs showing experiment results of the polarization P-voltage V characteristics when the doping concentrations of a channel layer in the semiconductor device of FIG. 1 are 1×10¹³ cm⁻³, 1×10¹⁴ cm⁻³ , and 1×10¹⁵ cm⁻³, respectively;
FIG. 6 is a graph showing remnant polarization 2Pᵣ and coercive voltage +V_{c} according to the doping concentration of a channel layer, which is calculated based on the results shown in FIGS. 5A to 5C;
FIG. 7 is a cross-sectional view of a semiconductor device according to another embodiment;
FIG. 8 is a perspective view of a semiconductor device according to another embodiment;
FIG. 9 is a cross-sectional view taken along line A-A' of FIG. 8;
FIG. 10 is a perspective view of a semiconductor device according to another embodiment.
FIG. 11 is a cross-sectional view taken along line B-B' of FIG. 10;
FIG. 12 is a cross-sectional view of a semiconductor apparatus according to various example embodiments;
FIGS. 13 and 14 are schematic conceptual views showing a device architecture that is applicable to an electronic apparatus according to various example embodiments;
FIG. 15 is a cross-sectional view of a semiconductor device, according to various example embodiments; and
FIG. 16 is a flow-chart illustrating a method of fabricating the semiconductor device illustrated in FIG 15, according to various example embodiments.

### DETAILED DESCRIPTION

Reference will now be made in detail to various example embodiments, examples of which are illustrated in the accompanying drawings, wherein like reference numerals refer to like elements throughout. In this regard, example embodiments may have different forms and should not be construed as being limited to the descriptions set forth herein. Accordingly, example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, various example embodiments will be described in detail with reference to the accompanying drawings. In the drawings below, like reference numbers denote like constituent elements, and the sizes of components in the drawings may be exaggerated for convenience of explanation. Various embodiments described below are merely examples, and various modifications and changes are available from the embodiments.

When a constituent element is disposed "above" or "on" to another constituent element, the constituent element may include not only an element directly contacting on the upper/lower/left/right sides of the other constituent element, but also an element disposed above/under/left/right the other constituent element in a non-contact manner. An expression used in a singular form in the specification also includes the expression in its plural form unless clearly specified otherwise in context. When a part may "include" a certain constituent element, unless specified otherwise, it may not be construed to exclude another constituent element but may be construed to further include other constituent elements.

The use of the terms "a" and "an" and "the" and similar referents in the context of describing the disclosure are to be construed to cover both the singular and the plural. Also, the steps of all methods described herein can be performed in any suitable order unless otherwise indicated herein or otherwise clearly contradicted by context. The disclosure is not limited to the described order of the steps.

Furthermore, terms such as "... portion," "... unit," "... module," and "... block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical and/or logical couplings between the various elements. It should be noted that many alternative or additional functional relationships, physical connections and/or logical connections may be present in a practical device.

The use of any and all examples, or language, e.g., "such as," provided herein, is intended merely to better illuminate the disclosure and does not pose a limitation on the scope of the disclosure unless otherwise claimed.

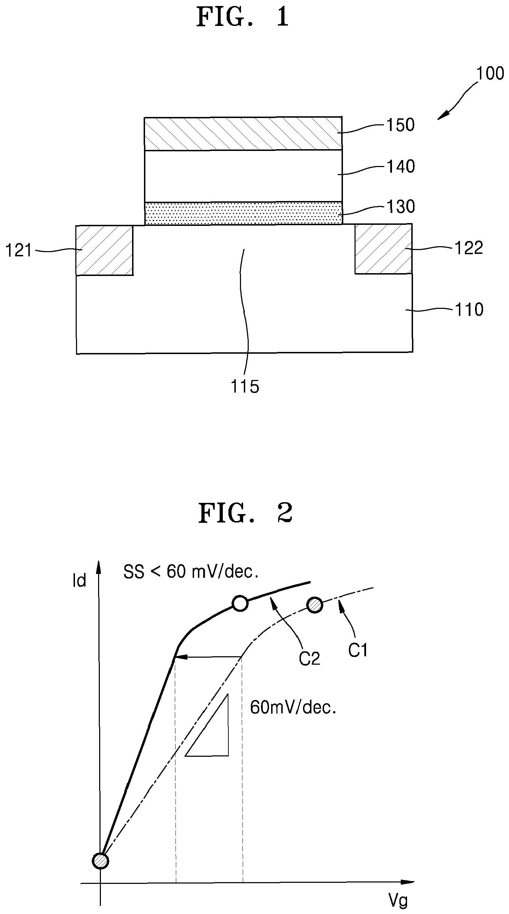

FIG. 1 schematically illustrates a semiconductor device 100 according to various example embodiments. The semiconductor device 100 of FIG. 1 may be or may include a field effect transistor (FET), such as an n-type FET (NFET) or a p-type FET (PFET), and may be planar or three-dimensional.

Referring to FIG. 1, the semiconductor device 100 may include a substrate 110, a ferroelectric layer 140, and a gate 150. A paraelectric layer 130 may be provided between the substrate 110 and the ferroelectric layer 140.

A channel layer 115 is integrally formed or integrally be part of or positioned at or near an upper portion of the substrate 110. The channel layer 115 is provided in the upper portion of the substrate 110 corresponding to the gate 150, and a source 121 and a drain 122 may be provided at opposite sides of the channel layer 115.

The source 121 may be electrically connected to one side of the channel layer 115, and the drain 122 may be electrically connected to the other side of the channel layer 115. The source and drain 121 and 122 may be formed by doping or implant, e.g. injecting, impurities into different regions of the substrate 110, and a region of the substrate 110 between the source 121 and the drain 122 may be defined as the channel layer 115. Accordingly, the channel layer 115 may be provided integrally with or within the substrate 110. However, as described below, a channel layer may be provided as a material layer separate from or at least partially separate from the substrate 110, not as a part of or included in the substrate 110.

The substrate 110 including the channel layer 115 may include a semiconductor material. For example, the substrate 110 may include, for example, one or more of Si, Ge, SiGe, a group III-V semiconductor, and the like. The substrate 110 may be formed from a Czochralski substrate and may be doped, e.g. may be lightly doped with one or more of boron, phosphorus, or arsenic during the Czochralski process; however, example embodiments are not limited thereto, and the substrate 110 may be initially undoped. Furthermore, the substrate 110 may include at least one of, for example, an oxide semiconductor, a nitride semiconductor, an oxynitride semiconductor, a two-dimensional (2D) semiconductor material, quantum dots, or an organic semiconductor. The oxide semiconductor may include, for example, InGaZnO and the like, the 2D semiconductor material may include, for example, transition metal dichalcogenide (TMD) or graphene, and the quantum dots may include colloidal quantum dots, a nanocrystal structure, and the like. However, this is merely an example, and example embodiments are not limited thereto.

The substrate 110 including the channel layer 115 may include a dopant of a certain concentration. The dopant may include a p-type dopant or an n-type dopant. The p-type dopant may include, for example, a group III element such as B, Al, Ga, In, and the like, and the n-type dopant may include, for example, a group V element such as P, As, Sb, and the like.

A semiconductor substrate including the p-type dopant at a particular dopant concentration in the channel layer 115 may be used as or for the substrate 110, and when the source and drain 121 and 122 include n-type impurities, the semiconductor device 100 having an NMOS structure may be implemented. A semiconductor substrate including the n-type dopant at a particular dopant concentration in the channel layer 115 may be used as the substrate 110, and when the source and drain 121 and 122 include p-type impurities, the semiconductor device 100 having a PMOS structure may be implemented.

In the semiconductor device 100 according to various example embodiments, the substrate 110 including the channel layer 115 may have a doping concentration of, for example, 1×10¹⁵ cm⁻³ to 1×10²¹ cm⁻³ within the channel layer 115. As a detailed example, the substrate 110 including the channel layer 115 may have a doping concentration within the channel layer of 1×10¹⁵ cm⁻³ to 1×10²¹ cm⁻³. More specifically, the channel layer may have a doping concentration of greater than or equal to 1×10¹⁵ cm⁻³ and less than or equal to 1×10¹⁸ cm⁻³.

The ferroelectric layer 140 is provided on the channel layer 115 of the substrate 110. A ferroelectric has a spontaneous dipole (electric dipole), for example, spontaneous polarization, because an electric charge distribution in a unit cell is non-centrosymmetric in a crystallized material structure. Furthermore, the ferroelectric has remnant polarization by a dipole when there is no external electric field. In the ferroelectric, the direction of polarization may be switched to a domain unit by an external electric field.

The ferroelectric layer 140 may include, for example, a fluorite-based material and/or a perovskite based material, and the like. The perovskite material may include, for example, PZT, BaTiO₃, PbTiO₃, and the like. The fluorite-based material may include, for example, at least one oxide selected from among Hf, Si, Al, Zr, Y, La, Gd, and Sr.

As a detailed example, the ferroelectric layer 140 may include at least one of a hafnium oxide (HfO), a zirconium oxide (ZrO), or a hafnium-zirconium oxide (HfZrO). The hafnium oxide (HfO), the zirconium oxide (ZrO), and the hafnium-zirconium oxide (HfZrO) constituting or included in the ferroelectric layer 140 may have a crystal structure of an orthorhombic crystal system. The ferroelectric layer 140 may further include a dopant of, for example, at least one of Si, Al, La, Y, Sr, or Gd. However, the materials stated below are merely an example, and various other materials may be used as the ferroelectric layer 140.

The paraelectric layer 130 may be provided between the channel layer 115 of the substrate 110 and the ferroelectric layer 140. The paraelectric layer 130 may include, for example, at least one of a silicon oxide, a silicon nitride, an aluminum oxide, a silicon oxynitride, a lanthanum oxide, or an yttrium oxide. However, example embodiments are not limited thereto.

The gate 150 is provided on the ferroelectric layer 140. The gate 150 may be arranged facing the channel layer 115 of the substrate 110. The gate 150 may include, for example, a conductive material such as one or more of a metal, a metal nitride, polysilicon such as doped polysilicon, a 2D conductive material, and the like.

In the semiconductor device 100 according to various example embodiments, as the ferroelectric layer 140 is formed between the channel layer 115 and the gate 150, subthreshold swing (SS) of the semiconductor device 100 may be reduced by voltage amplification according to a negative capacitance effect.

FIG. 2 is a graph showing an effect of improving the subthreshold swing (SS) characteristics of the semiconductor device 100 of FIG. 1. In FIG. 2, "C1" indicates the characteristics of an operating voltage Vg and a current Id of an existing silicon-based field effect transistor, and "C2" indicates the characteristics of the operating voltage Vg and the current Id of the semiconductor device (the semiconductor device 100) of FIG. 1.

Referring to FIG. 2, for the existing silicon-based transistor, the SS is known to have a limit of about 60 mV/dec. However, as the semiconductor device 100 according to various example embodiments of FIG. 1 uses the ferroelectric layer 140, voltage amplification is generated by the negative capacitance effect, and accordingly, the SS may be reduced to about 60 mV/dec or less. Accordingly, by amplifying a voltage applied to the semiconductor device 100, low-power driving may be possible and/or the semiconductor device 100 may be downscaled.

In a ferroelectric semiconductor device, when the doping concentration of a channel layer increases, remnant polarization Pᵣ and coercive voltage V_{c} increase, and in this case, the degradation of a ferroelectric may be accelerated occurring, for example, from repeated cycles of programming and erasing. In the semiconductor device 100 according to various example embodiments, by having a lower doping concentration of a channel layer from 1×10¹⁵ cm⁻³ to 1×10²¹ cm⁻³ compared with the doping concentration of the existing ferroelectric semiconductor device, the remnant polarization and the coercive voltage may be maintained low, and accordingly, a low-voltage operation may be effectively implemented, and the reliability of a device according to the repeated programming and erasing may be improved.

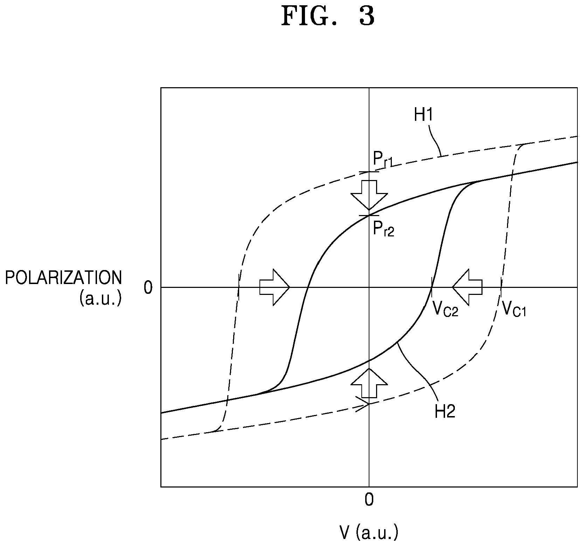

FIG. 3 is a graph schematically showing a hysteresis loop indicative of the polarization P-voltage V characteristics of a capacitor having a metal-ferroelectric-metal (MFM) structure and a capacitor having a metal-ferroelectric-insulator-metal (MFIM) structure. Hafnium-zirconium oxide (HfZrO) may be the ferroelectric, and a silicon oxide may be the insulator. In FIG. 3, "H1" indicates the polarization-voltage characteristics curve of an MFM structure, and "H2" indicates the polarization-voltage characteristics curve of an MFIM structure.

Referring to FIG. 3, it may be seen that remnant polarization Pᵣ₂ and coercive voltage V_{c2} of a capacitor having an MFIM structure are reduced compared with remnant polarization Pᵣ₁ and coercive voltage V_{c1} of a capacitor having a metal-ferroelectric-metal (MFM) structure because the strength of an electric field applied to a ferroelectric (hafnium-zirconium oxide) is decreased due to the insertion of an insulator (silicon oxide).

In the semiconductor device 100 having a metal-ferroelectric-insulator-semiconductor (MFIS) structure according to various example embodiments, by reducing the doping concentration of the channel layer 115 of the substrate 110 , the strength of an electric field applied to the ferroelectric layer 140 may be reduced, and accordingly, the remnant polarization and the coercive voltage may be reduced.

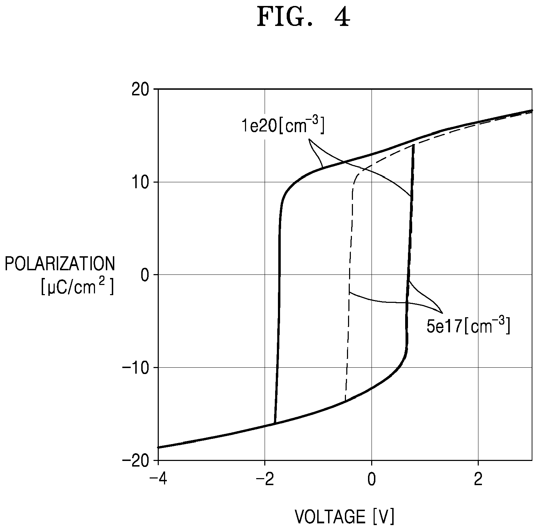

FIG. 4 is a graph showing a simulation result of the polarization P-voltage V characteristics when the doping concentration of a channel layer in the semiconductor device 100 of FIG. 1 is 1×10²⁰ cm⁻³ and 5×10¹⁷ cm⁻³. In this state, a hafnium-zirconium oxide (HfZrO) having a 7 nm thickness was used as the ferroelectric layer 140, and a silicon oxide having a 1 nm thickness was used as the paraelectric layer 130. Referring to FIG. 4, it may be seen that, by reducing the doping concentration of the channel layer 115, the remnant polarization and the coercive voltage are reduced.

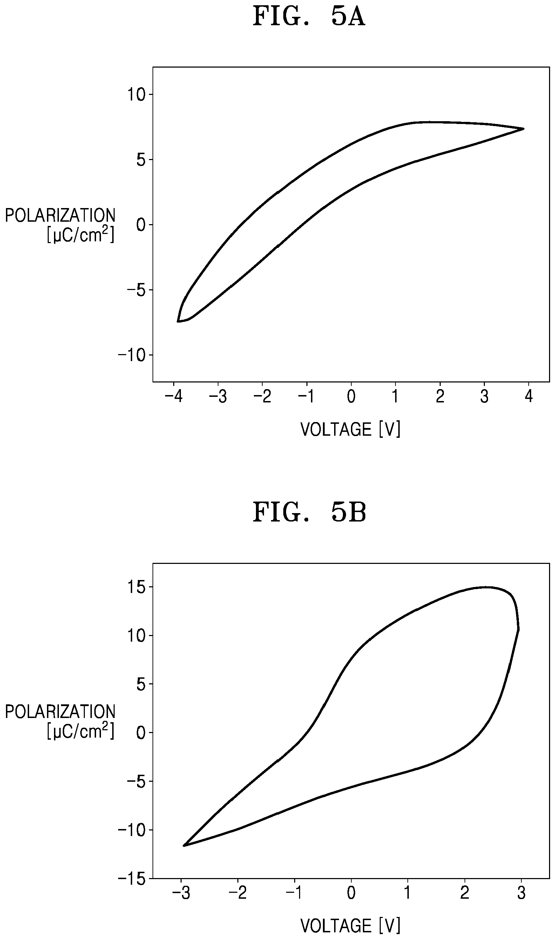

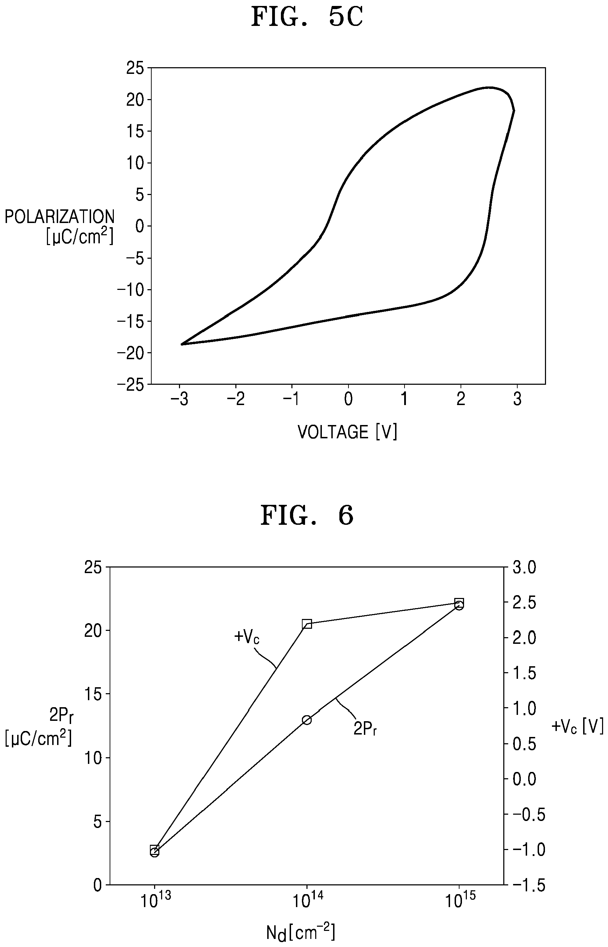

FIGS. 5A to 5C are graphs showing experimental results of the polarization P-voltage V characteristics when the doping concentrations of a channel layer in the semiconductor device 100 of FIG. 1 are 1×10¹³ cm⁻³, 1×10¹⁴ cm⁻³ , and 1×10¹⁵ cm⁻³, respectively. In this state, a hafnium-zirconium oxide (HfZrO) having a 7 nm thickness was used as the ferroelectric layer 140, and a silicon oxide having a 1 nm thickness was used as the paraelectric layer 130.

FIG. 6 is a graph showing remnant polarization 2Pᵣ and coercive voltage +V_{c} according to the doping concentration of the channel layer 115, which is calculated based on the results shown in FIGS. 5A to 5C. In FIG. 6, doping concentration N_{d} is expressed by the number of dopants per unit area. Referring to FIG. 6, it may be seen that, as the doping concentration of the channel layer 115 decreases, the remnant polarization 2Pᵣ and the coercive voltage +V_{c} are reduced.

In the semiconductor device 100 according to various example embodiments, by making the doping concentration of the channel layer 115 be within a range of 1×10¹⁵ cm⁻³ to 1×10²¹ cm⁻³, the remnant polarization 2Pᵣ may be about 20 [µC/cm²] or less, and the coercive voltage +V_{c} may be about 3[V] or less.

As described above, in the semiconductor device 100 according to various example embodiments, by making the doping concentration of the channel layer 115 be relatively lower than that of existing ferroelectric semiconductor device, the remnant polarization and/or the coercive voltage may be maintained low, and accordingly, the low-voltage operation may be more effectively implemented, and/or the reliability of a device according to the repeated programming and erasing may be improved.

The doping concentration of the channel layer 115 may be determined by various methods, such as but not limited to transmission electron microscopy (TEM) and/or secondary ion mass spectrometry (SIMS) such as time-of-flight SIMS (TOF-SIMS); however, example embodiments are not limited thereto.

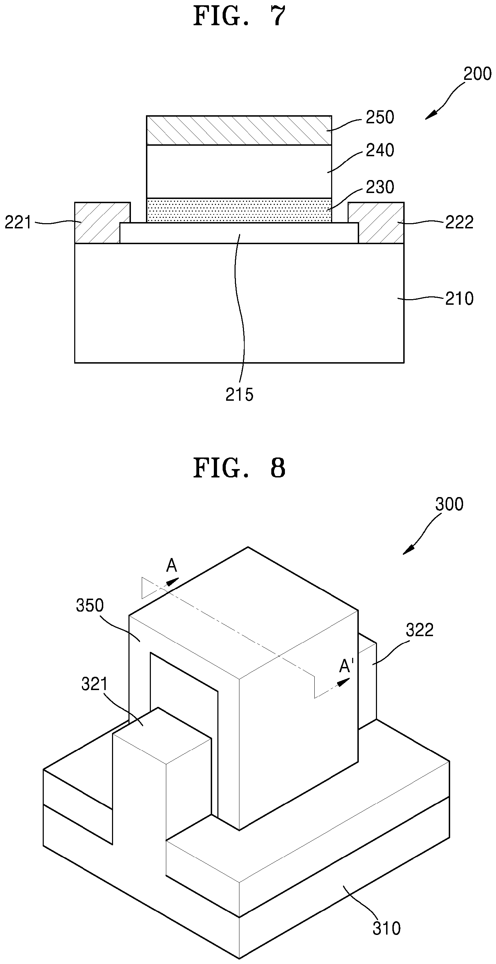

FIG. 7 is a cross-sectional view of a semiconductor device 200 according to various example embodiments. The semiconductor device 200 of FIG. 7 may be substantially the same as the semiconductor device 100 of FIG. 1, except that a channel layer 215 is provided separately from a substrate 210.

Referring to FIG. 7, the semiconductor device 200 may include the substrate 210, the channel layer 215, a paraelectric layer 230, a ferroelectric layer 240, and a gate 250. The channel layer 215 is provided on the substrate 210 corresponding to the gate 250, and a source 221 and a drain 222 may be provided at opposite sides of the channel layer 215.

The substrate 210 may include various materials. The channel layer 215 is provided on (e.g. directly on) an upper surface of the substrate 210. The channel layer 215 may be provided as a material layer separate from the substrate 210. The channel layer 215 may include at least one of, for example, an oxide semiconductor, a nitride semiconductor, an oxynitride semiconductor, a 2D material, quantum dots, or an organic semiconductor.

The channel layer 215 may include a dopant of a certain concentration. The dopant may include, for example, a p-type dopant including a group III element such as B, Al, Ga, In, and the like or an n-type dopant including a group V element such as P, As, Sb, and the like. The channel layer 215 may have, for example, a doping concentration of 1×10¹⁵ cm⁻³ to 1×10²¹ cm⁻³. As a detailed example, the channel layer 215 may have a doping concentration of 1×10¹⁵ cm⁻³ to 1×10²¹ cm⁻³.

The source 221 and the drain 222 may be provided at opposite sides of the channel layer 215. The source 221 may be provided to be connected to one side of the channel layer 215, and the drain 222 may be provided to be connected to the other side of the channel layer 215. The source and drain 221 and 222 may include a conductive material and may include the same, or different materials. The paraelectric layer 230, the ferroelectric layer 240, and the gate 250 are sequentially stacked on and above the channel layer 215, which is described above, and thus detailed descriptions thereof are omitted.

In various example embodiments as described above, the semiconductor devices 100 and 200, in which the channel layers 115 and 215 have a sheet or planar channel structure, are described as examples. However, the disclosure is not limited thereto, and a semiconductor device, in detail, a fin-FET, in which the channel layer has a fin channel structure, or a semiconductor device, in detail, a gate-all-around-FET, in which the channel layer has a gate-all-around channel structure, may be provided.

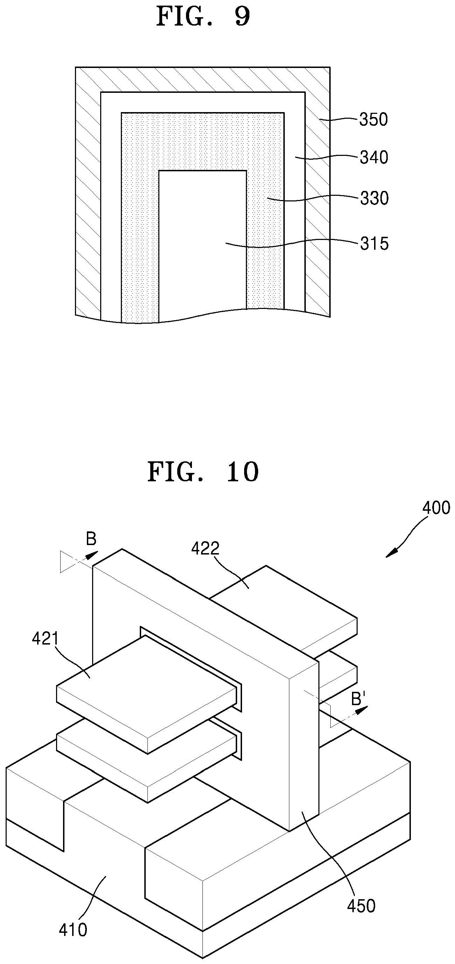

FIG. 8 is a perspective view of a semiconductor device 300 according to various example embodiments. FIG. 9 is a cross-sectional view taken along line A-A' of FIG. 8;

Referring to FIGS. 8 and 9, a source 321 and a drain 322 are provided at opposite sides above a substrate 310, and a region of the substrate 310 between the source 321 and the drain 322 may be defined as a channel layer 315. The channel layer 315 may have a fin shape. The channel layer 315, like the substrate 110 including the channel layer 115 according to various example embodiment described above, may have a doping concentration of 1×10¹⁵ cm⁻³ to 1×10²¹ cm⁻³. A gate 350 may be arranged to intersect with the channel layer 315 having a fin shape. A paraelectric layer 330 and a ferroelectric layer 340 may be provided between the channel layer 315 and the gate 350 to sequentially surround the channel layer 315.

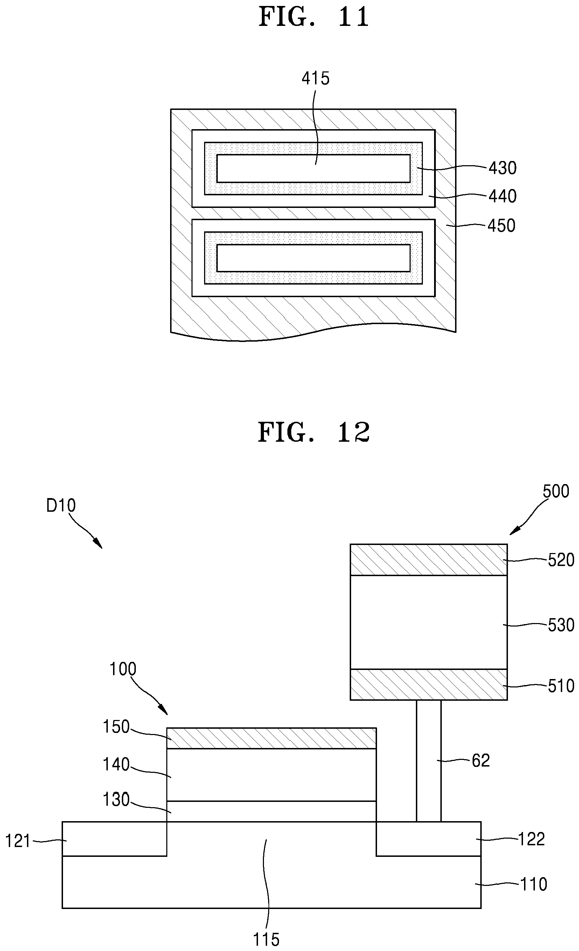

FIG. 10 is a perspective view of a semiconductor device 400, in detail, a gate-all-around-FET, according to another embodiment. FIG. 11 is a cross-sectional view taken along line B-B' of FIG. 10.

Referring to FIGS. 10 and 11, a channel layer 415 may be provided between a source 421 and a drain 422, and the channel layer 415 may have a shape of, for example, a sheet, a wire, and the like. The channel layer 415 may have a doping concentration of 1×10¹⁵ cm⁻³ to 1×10²¹ cm⁻³, as described above. The source 421, the drain 422, and the channel layer 415 may be arranged apart from a substrate 410. A gate 450 may be arranged to surround the channel layer 415 while intersecting with the source 421, the drain 422, and the channel layer 415. A paraelectric layer 430 and a ferroelectric layer 440 may be provided between the channel layer 415 and the gate 450 to sequentially surround the channel layer 415.

According to another aspect, a semiconductor apparatus including the semiconductor devices 100, 200, 300, and 400 described above may be provided. The semiconductor apparatus may include a plurality of semiconductor devices, and may be in the form in which a field effect transistor and a capacitor are electrically connected to each other. The semiconductor apparatus may have memory properties, for example, a dynamic random access memory (DRAM) device and the like.

FIG. 12 is a cross-sectional view of a semiconductor apparatus D10 according to various example embodiments.

Referring to FIG. 12, the semiconductor apparatus D10 may have a structure in which a field effect transistor or semiconductor device 100 and a memory element such as a two-terminal electrical component such as a capacitor 500 and/or a memristor are electrically connected to each other via a contact 62. FIG. 12 illustrates an example in which the semiconductor device 100 of FIG. 1 may be used as the semiconductor device 100. However, this is merely an example, and the semiconductor device 200 of FIG. 7, the semiconductor device 300 (fin-FET) of FIG. 8, or the semiconductor device 400 (gate-all-around-FET) of FIG. 10 may be used.

The capacitor 500 may include first and second electrodes 510 and 520 and a dielectric layer 530 provided between the first and second electrodes 510 and 520. One of the first and second electrodes 510 and 520 of the capacitor 500 may be electrically connected to one of the source and drain 121 and 122 of the field effect transistor or semiconductor device 100 via the contact 62. The contact 62 may include an appropriate conductive material, for example, one or more of tungsten, copper, aluminum, polysilicon, and the like. The capacitor 500 may be a linear capacitor, or may alternatively be a memristor memory element; however, example embodiments are not limited thereto.

The arrangement of the field effect transistor/semiconductor device 100 and the capacitor 500 may be variously changed. For example, the capacitor 500 may be arranged above the substrate 110 or may have a structure that is embedded in the substrate 110.

The semiconductor apparatus D10 described above may be applied to various electronic apparatuses. For example, the semiconductor apparatus D10 described above may be used for one or more of an arithmetic operation, program execution, temporary data retention, and the like in an electronic apparatus such as a mobile device, a computer, a notebook computer, a sensor, a network device, a neuromorphic device, and the like.

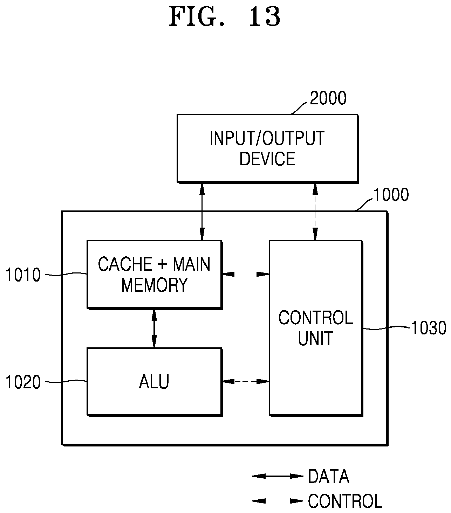

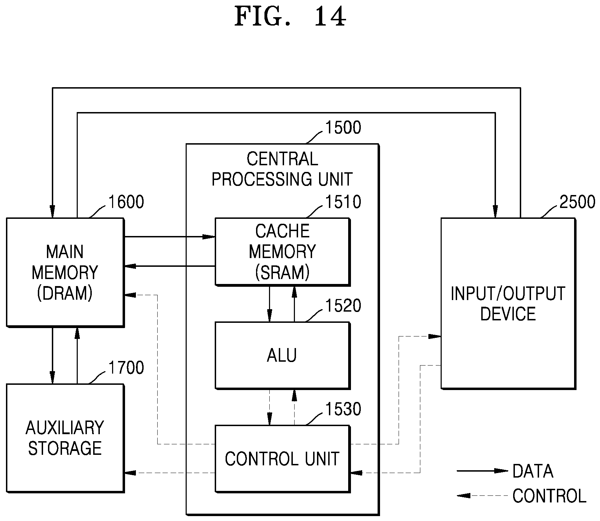

FIGS. 13 and 14 are schematic conceptual views showing a device architecture that is applicable to an electronic apparatus according to various example embodiments.

Referring to FIG. 13, an electronic device architecture 1000 may include a memory unit 1010, an arithmetic logic unit (ALU) 1020, and a control unit 1030. The memory unit 1010, the ALU 1020, and the control unit 1030 may be electrically connected to one another. For example, the electronic device architecture 1000 may be implemented as one chip including the memory unit 1010, the ALU 1020, and the control unit 1030. In detail, the memory unit 1010, the ALU 1020, and the control unit 1030 may be mutually connected by a metal line in an on-chip to directly communicate with one another. The memory unit 1010, the ALU 1020, and the control unit 1030 may be monolithically integrated on one substrate, thereby constituting one chip. An input/output device 2000 may be connected to the electronic device architecture 1000.

Each of or at least one of the memory unit 1010, the ALU 1020 and the control unit 1030 may independently include the semiconductor devices described above such as a field effect transistor, a capacitor and/or other passive device such as a memristor, and the like. For example, each of the ALU 1020 and the control unit 1030 may independently include the field effect transistor described above, and the memory unit 1010 may include the capacitor, field effect transistor, or a combination thereof, as described above. The memory unit 1010 may include both a main memory and a cache memory. The electronic device architecture 1000 may be an on-chip memory processing unit.

Referring to FIG. 14, a cache memory 1510, an ALU 1520, and a control unit 1530 may constitute a central processing unit (CPU) 1500. The cache memory 1510 may be static random access memory (SRAM) and may include the field effect transistor described above. Aside from the CPU 1500, a main memory 1600 and an auxiliary storage 1700 may be provided. The main memory 1600 may be DRAM and may include the capacitor described above. In some cases, the electronic device architecture 1000 may be implemented in the form in which computing unit devices and memory unit devices are adjacent to each other, in one chip, regardless of subunits.

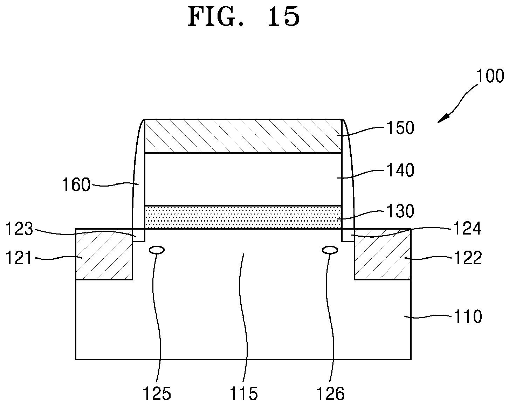

FIG. 15 is a cross-sectional diagram illustrating a semiconductor device according to some example embodiments. FIG. 15 may include some or all of the features of FIG. 1, and additional components are described.

Referring to FIG. 15, a semiconductor device 100 may include a substrate 110, a ferroelectric layer 140, and a gate 150. A paraelectric layer 130 may be provided between the substrate 110 and the ferroelectric layer 140.

The semiconductor device 100 may also include a spacer 160 on a sidewall of each of or at least one of the ferroelectric layer 140, the gate 150, and the paraelectric layer 130. The spacer may be or may include a nitride, such as silicon nitride; however, example embodiments are not limited thereto.

The semiconductor device 100 may further include a first lightly doped drain (LDD) 123 within the substrate 110, under the spacer 160, and between the channel 115 and the source 121. The first LDD 123 may include dopants at an impurity concentration less than that of the source 121. The dopants included in the first LDD 123 may be of the same conductivity type as dopants included in the source 121; however, example embodiments are not limited thereto.

The semiconductor device 100 may further include a second lightly doped drain (LDD) 124 within the substrate 110, under the spacer 160, and between the channel 115 and the drain 122. The second LDD 124 may include dopants at an impurity concentration less than that of the drain 122. The dopants included in the second LDD 124 may be of the same conductivity type as dopants included in the drain 122; however, example embodiments are not limited thereto.

The semiconductor device 100 may further include first and second halo or pocket regions 125 and 126. The first and second halo or pocket regions 125 and 126 may be doped with impurities of the conductivity type opposite to that of the source 121 and the drain 122; however, example embodiments are not limited thereto.

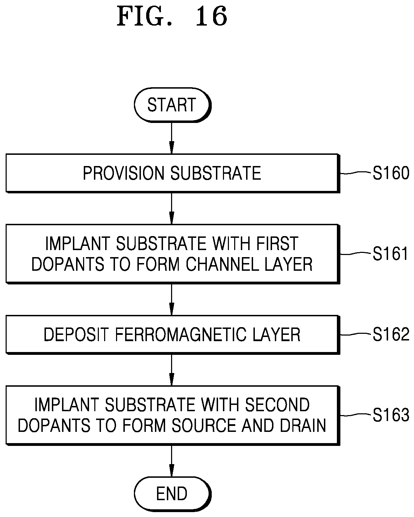

FIG. 16 is a flow diagram illustrating a method of fabricating the semiconductor device 100 described above.

Referring to FIG. 16, initially a substrate 110 may be provisioned (S160). Upon provisioning the substrate 110, the substrate 110 may be implanted, for example, with first dopants at a first dose (S161).

The dose of the first dopants may be such that the channel layer 115 is formed within the substrate 110 at a concentration of greater than or equal to 1×10¹⁵ cm⁻³ and less than or equal to 1×10²¹ cm⁻³. The implantation may be performed with a beamline implantation tool, and/or a plasma assisted doping tool, and may be performed one time or several times at the same dose or different doses and at the same energy or different energies.

A ferromagnetic layer 140 may be deposited on the channel layer 115 (S162). For example the ferromagnetic layer may be deposited with a chemical vapor deposition (CVD) process; however, example embodiments are not limited thereto.

The source and drain 121 and 122 may be formed (S163). The source and the drain 121 and 122 may be formed after the ferromagnetic layer 140 is formed. For example, the source and the drain 121 and 122 may be formed with an implantation process. Dopants in the implantation process may be of opposite conductivity type to that used in S161; however, example embodiments are not limited thereto.

In the ferroelectric semiconductor device according to the embodiments described above, by making the doping concentration of a channel layer relatively lower than the doping concentration of the existing ferroelectric semiconductor device, the remnant polarization value and the coercive voltage may be maintained low, and accordingly, a low-voltage operation may be more effectively implemented, and/or the reliability of a device according to repeated cycles of programming and erasing may be improved.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that embodiments described herein should be considered in a descriptive sense only and not for purposes of limitation. Descriptions of features or aspects within each variously described example embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a substrate having a channel layer on or in the substrate, the channel layer comprising a dopant;
a ferroelectric layer on the channel layer; and
a gate on the ferroelectric layer,
wherein the channel layer has a doping concentration of greater than or equal to 1×l0¹⁵ cm⁻³ and less than or equal to 1×10²¹ cm⁻³.

2. The semiconductor device of claim 1, wherein the channel layer is in an upper portion of the substrate integrally with the substrate, and a source and a drain are at opposite sides of the channel layer.

3. The semiconductor device of claim 1, wherein the channel layer is on the substrate at least partially separate from the substrate, and a source and a drain are provided at opposite sides of the channel layer.

4. The semiconductor device of any preceding claim, wherein the channel layer comprises at least one of Si, Ge, SiGe, a group III-V semiconductor, an oxide semiconductor, a nitride semiconductor, an oxynitride semiconductor, a two-dimensional, 2D, semiconductor material, quantum dots, or an organic semiconductor.

5. The semiconductor device of any preceding claim, wherein dopants included in the channel layer comprise at least one of a group III element or a group V element.

6. The semiconductor device of any preceding claim, wherein the channel layer has a doping concentration of greater than or equal to 1×10¹⁵ cm⁻³ and less than or equal to 1×10¹⁸ cm⁻³.

7. The semiconductor device of any preceding claim, wherein the ferroelectric layer comprises a fluorite-based material or a perovskite-based material.

8. The semiconductor device of claim 7, wherein the ferroelectric layer comprises at least one of a hafnium oxide, a zirconium oxide, or a hafnium-zirconium oxide.

9. The semiconductor device of claim 8, wherein the ferroelectric layer further comprises a dopant of at least one of Si, Al, La, Y, Sr, or Gd.

10. The semiconductor device of any preceding claim, further comprising:
a dielectric layer between the channel layer and the ferroelectric layer.

11. The semiconductor device of claim 10, wherein the dielectric layer comprises at least one of a silicon oxide, a silicon nitride, an aluminum oxide, a silicon oxynitride, a lanthanum oxide, or an yttrium oxide.

12. The semiconductor device of any preceding claim, wherein the channel layer comprises a planar channel structure, a fin channel structure, or a gate-all-around channel structure.

13. The semiconductor device of any preceding claim, wherein the gate comprises one or more of a metal, a metal nitride, polysilicon, or a two-dimensional, 2D, conductive material.

14. A semiconductor apparatus comprising:
a field effect transistor; and
a two-terminal electrical component electrically connected to the field effect transistor,
wherein the field effect transistor comprises a semiconductor device according to any preceding claim.

15. An electronic apparatus comprising the semiconductor apparatus according to claim 14.
